# EUROPEAN PATENT APPLICATION

(11) **EP 1 605 499 A2**
(43) Date of publication of application: **14.12.2005**
(21) Application number: 05447132.1
(22) Date of filing: 07.06.2005
(51) Int. Cl.: H01L 21/20, H01L 31/18

(54) **Method for manufacturing a crystalline silicon layer**

(30) Priority: 07.06.2004 US 577556
(71) Applicant: Interuniversitair Microelektronica Centrum, 3001 Leuven (BE)
(72) Inventor: Van Gestel, Dries Els Victor, B-2350 Vosselaar (BE); Beaucarne, Guy, B-3050 Oud-Heverlee (BE)
(74) Representative: Bird, William Edward

(57) **Abstract**

The present invention relates to a method for the formation of a crystalline silicon layer on a face of a substrate, the face being microrough, comprising the steps of:
providing the substrate (1a);
reducing the microroughness of the face (1b);
performing a metal induced crystallisation (2a) process on the face.

## Description

### Field of the invention

The present invention relates to the field of manufacturing methods for crystalline silicon layers on a substrate. More specifically it relates to a Metal Induced Crystallisation process. The present invention further relates to the application of such a method in the manufacturing process of electronic devices as for instance solar cells.

### Background of the invention

Thin-film crystalline Si solar cells on cheap foreign substrates are a promising alternative to traditional bulk crystalline silicon solar cells because of their higher potential for cost reduction. However, most of these approaches so far have led to devices with much lower efficiency than traditional solar cells. A major reason is the lower crystallographic quality of the layers obtained by deposition and/or crystallization.

A solution to obtain thin films of good crystallographic quality is to use the metal-induced crystallization phenomenon (MIC), also known as metal induced layer exchange phenomenon, to create a thin layer with large grains, typically followed by epitaxial deposition. Examples of this technique are given in for instance S. Gall, J. Schneider, M. Muske, I. Sieber, O. Nast, W. Fuhs, Proceedings PV in Europe (2002) 87; N.-P. Harder, J. A. Xia, S. Oelting, O. Nast, P. Widenborg, A. G. Aberle, Proceedings 28th IEEE PVSC (2000); S. Brehme O. Nast, D. Neuhaus, S. Wenham, IEEE trans. el. Dev. 46 (1999) 2062. One particular example of MIC is aluminum induced crystallization (AIC).

The MIC procedure can be summarized as follows:
- First a metal layer, e.g. an aluminum layer, is deposited on a foreign substrate;
- The metal layer, e.g. aluminum layer, is oxidized (for instance by exposure to air) to form a thin layer of metal oxide, e.g. aluminum oxide;
- Then amorphous silicon is deposited on the metal oxide layer, e.g. aluminum oxide layer;
- The sample is then annealed at a temperature below the eutectic point.

During annealing a layer exchange takes place: the silicon atoms diffuse into the metal layer, e.g. Al layer, crystallize together, while the metal atoms, e.g. Al atoms, move to the top surface. In case the layer exchange process is successful, the final structure consists of a continuous layer of large grain polysilicon on the foreign substrate covered by a metal layer, e.g. an Al layer, with Si enclosures. The metal layer, e.g. Al layer, is then etched away. The seeding layer so produced may contain some secondary crystallites that were formed in the top metal layer, e.g. Al layer, during crystallization. These secondary crystallites are referred to as 'islands'.

In the following step, a layer can be deposited epitaxially on the seed layer, reproducing the grain structure of the seed layer.

If the epitaxy process can be done at low temperature (e.g. ECR PECVD, lon-assisted deposition,...), cheap glass can be used. In the context of solar cell manufacturing, this can possibly lead to very low cost solar cells, but low temperature epitaxy on imperfect surfaces presents a serious technological challenge.

Alternatively, the epitaxial growth can be done with a high temperature technique (e.g. thermal chemical vapour deposition). Using a high temperature technique has important advantages (good epitaxial quality with simple process), but also imposes restrictions on the possible foreign substrates. Standard cheap glass cannot be used because it cannot withstand high temperatures.

Therefore often ceramic substrates are considered for the high temperature route. At present most of the research on AIC for thin film solar cells on foreign substrates is done on glass. On glass the poly-silicon layer is very smooth with less islands of silicon. Aluminum-induced crystallization on ceramic however results in an average grain size that is low, ~ 1-2 micron, and a high density of islands.

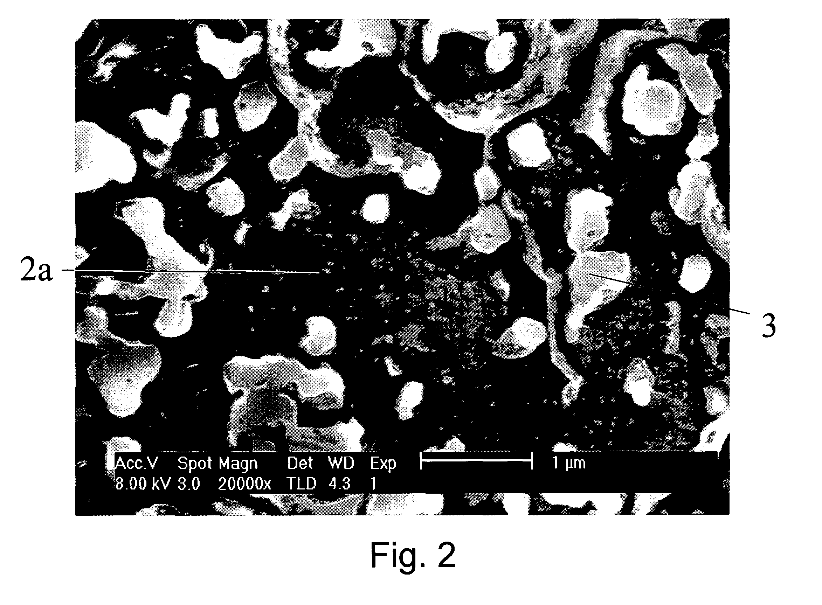

In "Formation of polycrystalline silicon on foreign substrates by combination of CVD and Aluminium-Induced crystallisation techniques", E Pihan, A. Slaoui, M. Rusu, Conference "PV in Europe", Rome 2002, nucleation and growth of polycrystalline silicon layers on foreign substrates using the Aluminium induced crystallisation process (AiC) of amorphous silicon is presented. The foreign substrates used are mullite ceramic substrates as well as thermally-oxidized silicon substrates. It is shown that the combination of AIC and thermal CVD can be applied on ceramic substrates, though the quality of the resulting crystalline silicon layer is much lower on the mullite substrates then on the thermally-oxidized silicon substrates, illustratively shown in Fig. 2 of this paper, as the density of grains on mullite substrates is much higher than the density of grains on thermally oxidized silicon substrates, and thus the grain size much smaller.

Parameters that can define the quality of a crystalline film created by an MIC technique are grain size, continuity of the layer, island density, crystallographic properties (defects, grain boundaries,...) and electrical properties.

Crystals are referred to herein based on their grain sizes, as provided in Table 1. The term "crystalline silicon" refers to silicon of all crystal types, but excludes amorphous silicon.

**Table 1**

| Grain size of silicon crystal | Name |
|---|---|
| Atomic size | Amorphous |
| Atomic size - 10 nm | Nanocrystalline |
| 10 nm - 1 µm | Micro crystalline |
| 1 µm - 100 µm | Polycrystalline |
| 100 µm - 1 mm | Multi crystalline |
| > 1 mm up to Infinite | Mono crystalline |

### Aim of the invention

It is an aim of this invention to provide for a method for manufacturing a crystalline silicon layer on a substrate, which alleviates or avoids the problems of the prior art. The crystalline silicon layer should be good enough to produce silicon solar cells.

### Summary of the invention

For the purpose of this invention, a microrough surface is a surface which has a roughness at a microscale. Microroughness is roughness at microscale. Microroughness differs from the in the art typically used measure for roughness; RMS roughness, which is macroroughness. A surface can for instance be rough, or thus macrorough, but not microrough. Alternatively, a surface can be macroflat and at the same time microrough.

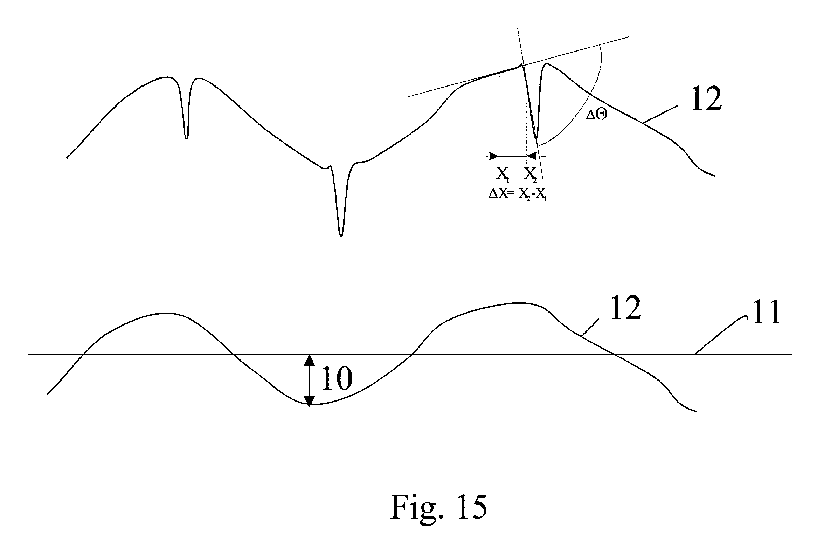

The degree of microroughness can be quantified in a parameter µRN, defined as the relative mean distance, with his variance, between two side by side, along a characteristic profile line of the surface, microrough defects. A microrough defect is a place were |ΔΘ/Δx| (absolute value) is higher than a given value. For example this value can be higher than 1rad/µm, preferably higher than 2rad/µm. ΔΘ is the angle between two tangential lines to a characteristic profile line of the surface in a point x₁ and x₂, and Δx=x₂-x₁ the distance between the orthogonal projections of two points x₂ and x₁ onto a parallel of a least square fitted straight line of the characteristic profile line (illustrated in Fig. 15). Hereby Δx is preferably in the order of between 0.03µm and 0.5µm, preferably between 0.05µm and 0.3µm, typically about 0.1µm.

A surface is microrough if any location on the surface can be found where |ΔΘ/Δx|>1rad/µm.

The relative mean distance between two microrough defects must be calculated from a characteristic profile for the sample, having a length L measured along a least square fitted straight line of the surface, with resolution between 5 nm and 20 nm over the surface in consideration. Divide the profile in L/Δx equal parts and calculate for every part the value |ΔΘ/Δx| and decide if the value is higher than the given value or not. L/Δx must be large enough in order to allow statistical analysis. With all these values |ΔΘ/Δx| at definite places it is possible to calculate the mean distance dₘ between two side-by-side microrough defects along the characteristic profile. To get the relative mean distance divide the mean distance dₘ by L, µRN=dₘ/L, resulting in a value between 0 and 1. The higher the value, the lower the microroughness of the sample will be. The lower the value, the higher the microroughness of the sample will be.

Other examples of suitable parameters as a measure for microroughness can be easily provided.

The values of Θ can be determined from a cross-sectional profile (e.g. cross-sectional transmission electron microscope picture) with resolution between 5 nm and 20 nm.

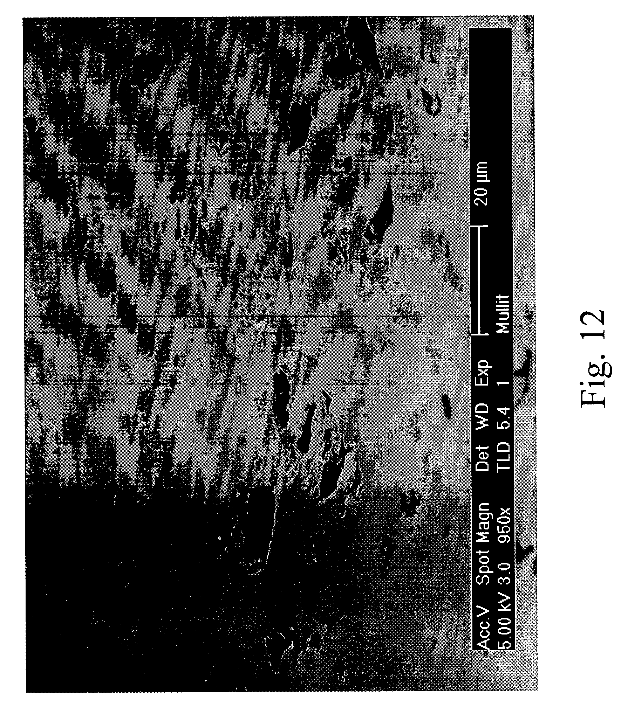

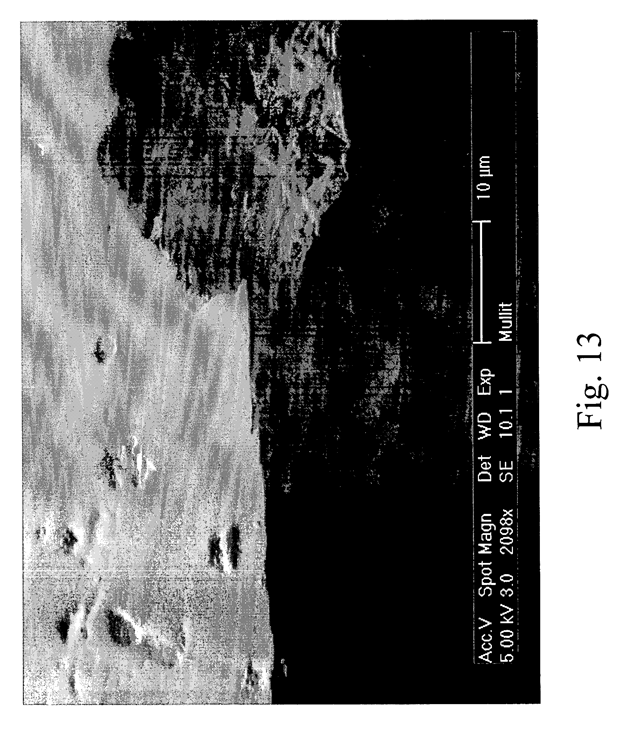

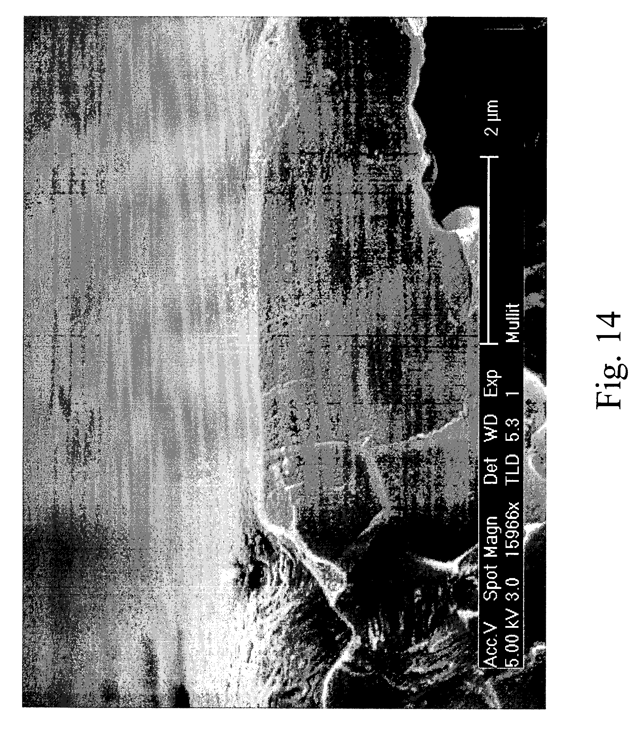

The ceramic substrates used in some of the experiments disclosed are commercial mullite substrates. The polishing of these substrates leads to large open porosity (pores several micron deep and wide), which cannot be excluded with polishing (see Fig. 12, Fig. 13 and Fig. 14). The quality of the MIC film, e.g. AIC film, should be evaluated on the substrate material between these large pores.

The present invention provides a method for improving the MIC, especially e.g. the AIC process on microrough substrates as for instance ceramic substrates, as for instance mullite or alumina substrates.

It is believed that the quality of the polycrystalline layer resulting from the MIC, especially AIC process is at least partially determined by the microroughness of the underlying layer.

The present invention discloses a method for the formation of a crystalline silicon layer on a face of a substrate, the face being microrough, the method comprising the steps of:
providing the substrate;
reducing the microroughness of the face; and
performing a metal induced crystallisation process on the face.

Different possibilities are disclosed for reducing the microroughness of the face.
The surface can for instance be polished. In preferred embodiments according to the present invention, the reduction of the microroughness of the microrough face is performed by depositing a microflattening layer on this microrough face.
The microflattening layer is preferably a dielectric layer, for example an oxide layer, but is not limited thereto. The intermediate dielectric layer should lead to a substrate surface with a smaller microroughness. In that case this results in an MIC seed layer, e.g. an AIC seed layer, with much larger grains and a much lower islands density. After the epitaxial deposition, a polycrystalline silicon layer on ceramic with large grain size is obtained. With large grain size is meant a grain size larger than 5µm.

The initial microrough substrate preferably comprises a ceramic material, glass or a glass-ceramic material. The substrate can be any microrough substrate. Preferably it comprises mullite, alumina or Silicon Nitride.

Any reduction of microroughness of the underlying layer or substrate results in a better performance of the MIC, e.g. AIC, process on top. The value µRN indicates on which substrate MIC, e.g. AIC, will give the best results. An additional microroughness reducing step can be applied. The same step may have a different impact on the microroughness of different substrates.

Since the µRN parameter only takes into account geometric features of a substrate surface, it is believed that its use for comparing µRN values is even more appropriate when comparing values on the same types of substrates, or still more appropriate when comparing values on a single substrate before and after a microflattening step. It can of course also be used to develop techniques for performing microflattening steps.

Preferably the dielectric comprises a spin-on dielectric, e.g. spin-on oxide, a flowable dielectric, e.g. flowable oxide (which can sometimes also be a spin-on oxide), a dip-on dielectric, e.g. dip-on oxide, or a spray-on dielectric, e.g. spray-on oxide. More preferably the dielectric may comprise a spin-on glass or SiO₂.

The metal induced crystallisation process is preferably a Aluminum induced crystallisation process.

The metal or Aluminum induced crystallisation process is known in the art, and typically comprises the steps of (e.g. AIC):
a. Metal, e.g. Aluminium, deposition;
b. Metal, e.g. Aluminium, oxidation;
c. Amorphous silicon deposition;
d. Annealing;
e. Metal, e.g. Al, removal.

The resulting seed layer can then advantageously be used for further epitaxial layer deposition, resulting in a polycrystalline layer of high quality. This epitaxially deposited layer can then advantageously be used for solar cell applications and manufacturing.

Any standard solar cell processing can be performed; hereby the following steps are mostly present:
- Phosphor diffusion for emitter formation or heterojunction emitter formation
- Bulk and surface passivation
- Metallisation
- Isolation

The present invention also includes a substrate with a buried microrough surface, a microflattening layer on the microrrough surface, and a seed layer. A crystalline semiconductor layer can be provided on the seed layer. A solar cell can include the substrate.

### Description of the figures

Fig. 1 is a SEM top view of an AIC layer formed directly on a ceramic (Alumina) substrate.
Fig. 2 is a SEM top view of an AIC layer formed on a ceramic substrate covered by pyrolithic oxide.
Fig. 3 is a SEM top view of an AIC layer formed on a ceramic substrate covered by a spin-on flowable oxide.
Fig. 4 is a SEM picture of a thin silicon grain formed by AIC on a spin-on oxide coated ceramic substrate. The wavy substrate surface and the islands on top of the grains are to be noted.
Fig.5 is a TEM picture of a sample with structure ceramic/spin-on oxide/AIC/epitaxial layer.
Fig. 6 is an optical microscope picture of an epi layer grown on an alumina ceramic/spin-on oxide/AIC seed layer sample, after polishing and Secco etch. SIMS measurements were carried out on such a sample. The dopant profile was as expected. The oxygen concentration was found to be constant throughout the layer at around 6 × 10¹⁷ cm⁻³.
Fig. 7 shows sample 4: non-polished mullite/AIC
Fig. 8a shows sample 1: polished mullite/AIC
Fig.8b is a SEM image of sample 1
Fig. 9 shows sample 8:non-polished mullite/spin-on oxide/AIC
Fig. 10a shows sample 5: polished mullite/spin-on oxide/AIC
Fig. 10b is a SEM image of sample 5: polished mullite/spin-on oxide/AlCFig.11a shows sample 9: alumina/spin-on oxide/AIC
Fig.11b is a SEM image of an alumina/spin-on oxide/AIC sample
Fig. 12 is a SEM tilted view of a polished mullite sample
Fig. 13 is a SEM tilted cross section of a polished mullite sample
Fig. 14 is a SEM cross-section of a polished mullite sample
Fig. 15 is an illustration of the difference between macroroughness and microroughness; both surfaces illustrated are rough and have about the same RMS roughness. Their microroughness differs though, the upper part of the drawing showing a larger microroughness than the bottom part, resulting in different MIC process qualities.
Fig.16 is a cross-sectional view of a sample ceramic/spin-on oxide/AIC layer. The spin-on oxide layer was thinner compared to the other samples with a spin-on oxide layer (except Fig. 18 which is from the same sample).
Fig.17 is a cross-sectional view of a sample ceramic/spin-on oxide/AIC layer with double spin-on oxide layer.
Fig.18 is a top view optical microscope picture of a sample ceramic/spin-on oxide/AIC layer after Aluminum removal (127*95.5µm²). The spin-on oxide layer was thinner compared to the other samples with a spin-on oxide layer (exept Fig. 16 which is from the same sample).
Fig.19 is a top view optical microscope picture of a sample ceramic/spin-on oxide/AIC layer after epitaxial growth (127*95.5µm²).
Fig.20 is a top view optical microscope picture of a sample ceramic/spin-on oxide/AIC layer with double spin-on oxide layer after Aluminum removal (127*95.5µm²).
Fig.21 is a top view optical microscope picture of a sample ceramic/spin-on oxide/AIC layer with double spin-on oxide layer after epitaxial growth (127*95.5µm²).
Fig. 22 is a SEM image of a sample alumina (without spin-on oxide) with AIC. An EBSD map was only possible on 0.3% of the total surface of this sample, resulting in substantially uniform black picture, linked to the roughness of the sample.
Fig. 23 is and EBSD map of a sample alumina with spin-on oxide and AIC. Fig. 11b is a SEM picture of the same area.
Fig. 24 is an EBSD map of a sample, polished mullite with AIC seed layer.

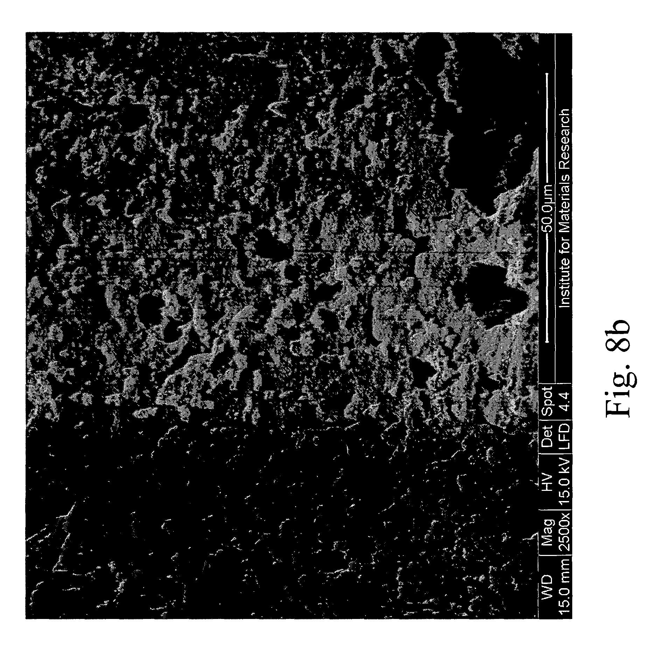

Fig. 8b is a SEM picture of the same area.

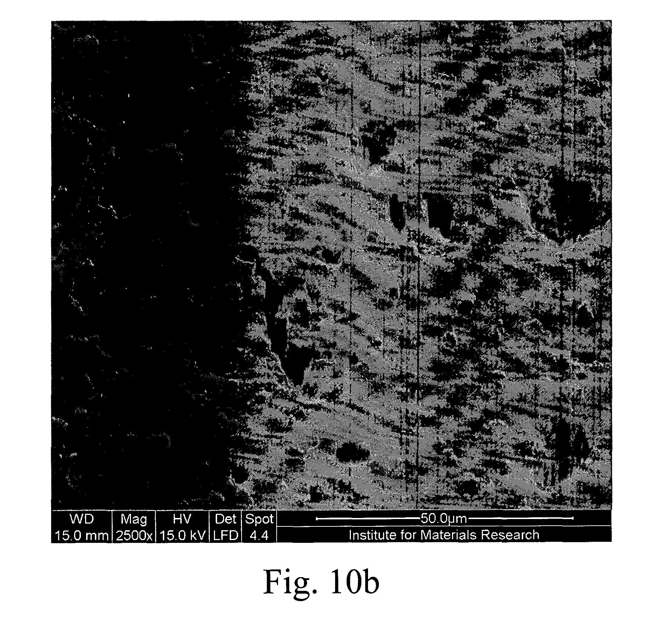

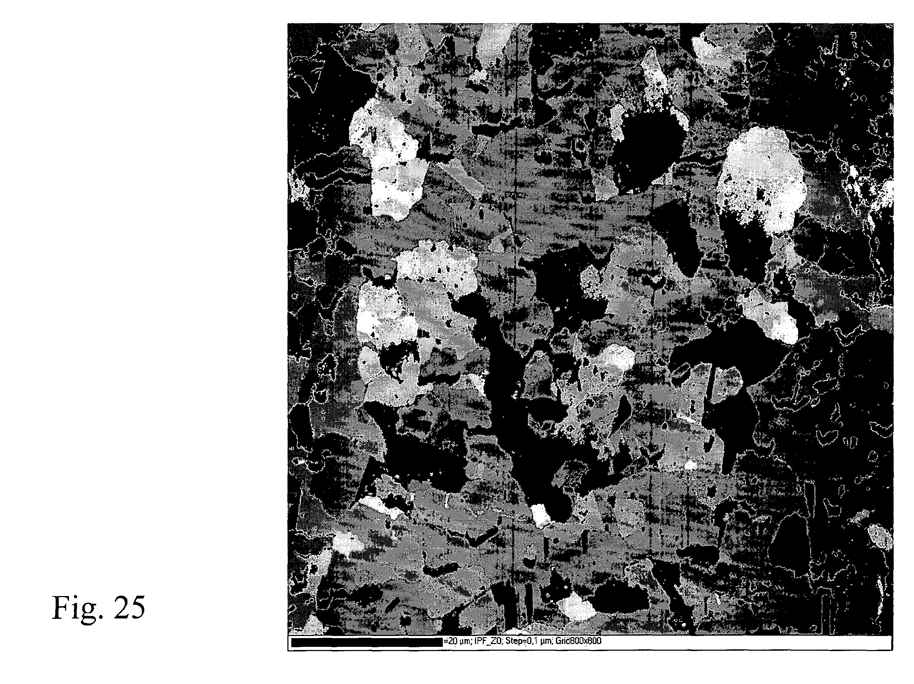

Fig. 25 is an EBSD map of a sample of polished mullite with spin-on oxide and AIC seed layer. Fig. 10b is a SEM picture of the same area.

The figures with EBSD samples are depicted at the original aspect ratio and the x and y dimensions both have the same scale, as shown. The scale itself is part of the figures and is therefore not deformed with respect to the figures.

### Detailed description of the invention

The present invention is described in detail below. It is apparent, however, that a person skilled in the art can imagine several other equivalent embodiments or other ways of executing the present invention, the spirit and scope of the present invention being limited only by the terms of the appended claims. Next to high temperature resistance, the substrates, e.g. ceramic substrates, for use with the present invention have to fulfil several other criteria regarding thermal expansion, chemical stability and optical properties. Alumina (microcrystalline aluminium oxide) and mullite (mixture of SiO₂ and Al₂O₃) substrates have been used for the examples given below.
The bulk of the literature on AIC deals with doing the process on glass substrates. It is however not straightforward to extend this experience to ceramic substrates. The conditions are very different. Whereas glass substrates usually have a very flat surface (macroroughness below 10 nm and microflat), the ceramic substrates show a large macroroughness, ranging from 50 nm up to microns and are moreover microrough. This surface structure results from the sintering process which occurs during ceramic production. The alumina substrates used for the present invention had a peak to peak roughness of about 400 nm (RMS roughness ~ 80 nm). Moreover, ceramic consists at least in part of a crystalline phase, in contrast to the amorphous structure of glass.
The degree of macroroughness can be quantified by the maximum deviation from an average level line 11, as illustrated in Fig.15. An average level line 11 is a reference line from which profile deviations are measured. As an average level line 11, one can use the least squares mean line, which is a line through a profile 12 such that the sum of the squares of the deviations 10 of the profile from the average level line 11 is minimised. A measure for the macroroughness can be the maximum deviation from this average level line 11.

Such average level line 11 can be determined from cross-sectional SEM or TEM pictures over a distance of minimum 1 µm and long enough to have a characteristic profile for the sample (typically maximum 15 µm). A surface is defined as macrorough when the maximum deviation from the average level line 11 exceeds 50 nm. If not, the surface is defined to be macroflat.

In Fig.15, the difference between macroroughness and microroughness is illustrated. Both profiles 12 illustrated are macrorough and have about the same RMS roughness. However, the top profile 12 has a larger microroughness than the bottom profile 12.

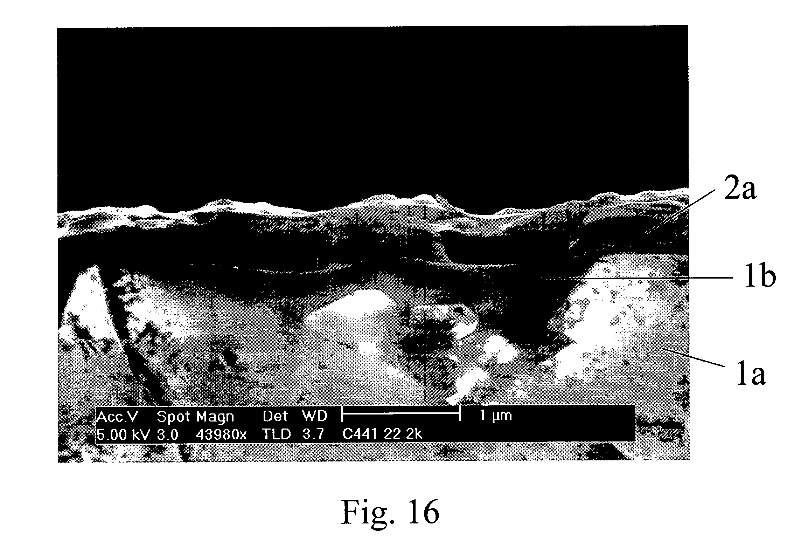

In Fig.16, a cross-section is shown of a sample ceramic/spin-on oxide/AIC layer. The ceramic substrate 1a has a macrorough and microrough surface. The spin-on oxide layer has a microflat but macrorough interface with the AIC seed layer 2a.

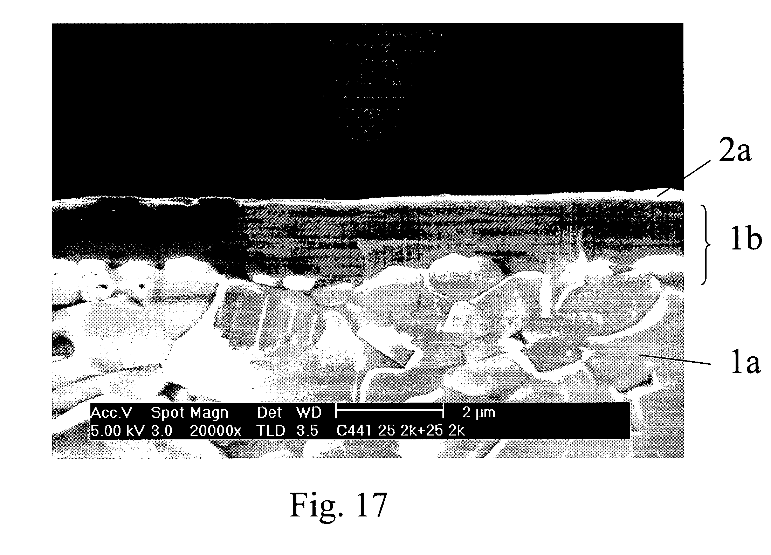

Fig.17 shows a cross-section of a sample ceramic/spin-on oxide/AIC layer with double spin-on oxide layer. The ceramic substrate 1a has a macrorough and microrough surface. The interface between the double spin-on oxidelayer 1b and the AIC seed layer 2a is both micro- and macroflat.

### Examples:

The substrates used were alumina substrates ADS996 from CoorsTek. Double layers of Aluminum and amorphous silicon were deposited one after the other, allowing the aluminium layer to get oxidized between the two depositions by a 2 min exposure to air. The aluminium deposition has been done in an electron-beam, high-vacuum evaporator. The amorphous Silicon layer was either deposited in the same evaporator, or in a parallel plate plasma-enhanced CVD system from silane decomposition. A typical stack was 200 nm Al and 230-250 nm Si. These structures were then annealed in a tube furnace under nitrogen ambient at 500 °C for a period of 30 min to 4 hours. During the annealing, crystalline silicon grains are formed in the bottom layer while Al atoms move to the top surface, eventually resulting in a layer exchange. The top Al layer is then removed in a chemical solution based on phosphoric acid.

### Results with AIC on bare ceramic substrate 1a:

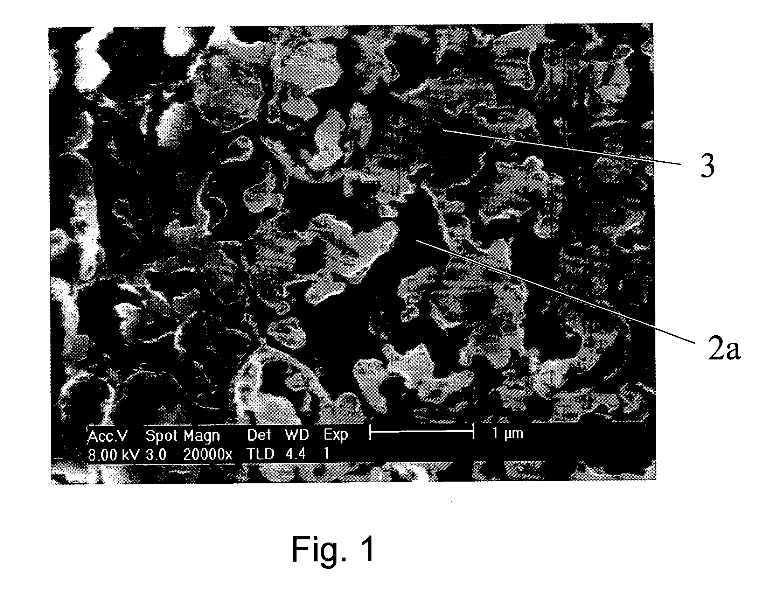

The morphology of a typical sample obtained with the procedure described above can be seen in the SEM picture in Figure 1. The AIC seed layer 2a as such is not clearly visible in this picture. The reason is that the layer 2a is covered by numerous 'islands' 3, the secondary crystallites formed within the top layer during the AIC process. Close observation with SEM and TEM analysis reveals that the grain size in the AIC seed layer 2a is around 1-2 µm. This grain size is substantially lower than reported results on glass. There appears to be much more nucleation taking place when the AIC is done on a ceramic substrate 1a, both in the bottom layer (leading to a small grain size) and in the top layer (leading to a high density of islands).

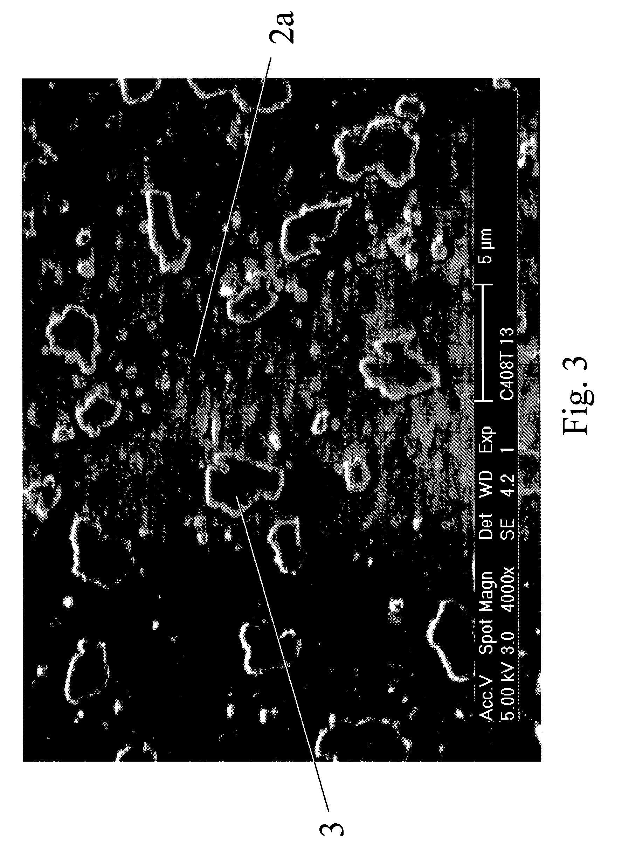

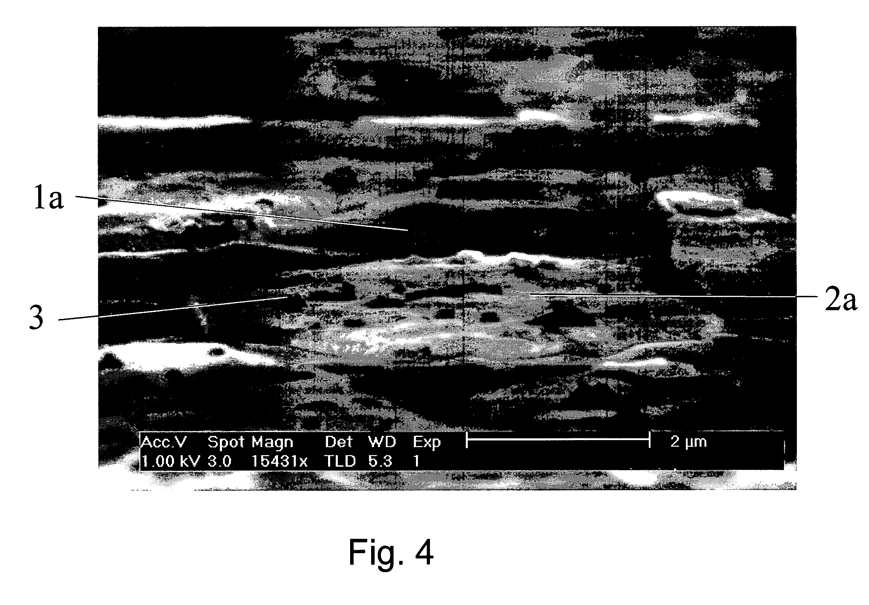

Results with an intermediate layer applied in order to reduce the microroughness:
An intermediate silicon oxide layer has been introduced between the substrate 1a and the AIC layers. Two different types of oxide have been used. One type is a pyrolithic oxide ('pyrox') deposited by the decomposition of silane at atmospheric pressure and 400 °C. The second type is a spin-on flowable oxide (FOx-23 from Dow Corning), cured at 400 °C. Pyrox was densified at 950 °C and the spin-on flowable oxide at 900°C before the deposition of the AIC stack. SEM pictures of these samples are shown in Figure 2 and Figure 3, respectively. The density of islands 3 decreases drastically, by about a factor two for the intermediate pyrox layer (Fig. 2), and another factor 2 for the spin-on oxide layer (Fig. 3). The appearance of the latter samples is however completely different. Because there are much less islands 3 in case of the spin-on oxide as the intermediate layer than in the other two cases, the structure of the main AIC seeding layer 2a is clearly visible, and is in fact reminiscent of what is obtained on glass substrates. The layer 2a consists of roughly circular large grains (> 5 µm), the growth of which is stopped by the encounter with a neighbouring grain. If the process is not allowed to proceed to full completion, or, as for these samples, the excess of Si is not sufficient, holes remain in the AIC seed layer 2a. The different features are even more evident in the tilted view of an AIC grain on a ceramic substrate 1a with intermediate spin-on oxide 1b in Figure 4. One single large grain is seen in the centre of this picture, the surface of the substrate 1a being visible all around it. It is interesting to note that the surface of the substrate 1a is clearly not macroflat, but shows substantial waviness and thus RMS roughness. The peak to peak roughness is still larger than 100 nm. Nevertheless, the AIC grain growth proceeds along the substrate surface, resulting in a single grain. This surface is though microflat. It is believed that the quality of the polycrystalline layer resulting from the AIC process is at least partially determined by the microroughness of the substrate surface.

This tolerance to not perfectly flat substrates is a strength of the AIC process, which is not only useful for ceramic substrates but also for glass substrates. Although the SEM picture in Figure 4 shows a not yet complete AIC seed layer 2a, it is relatively simple to achieve such a complete layer by tuning the properties of the AIC stack.

### Epitaxial silicon deposition:

After removal of the metal layer obtained on top of the stack at the end of the MIC process, e.g. an Al layer in case of a AIC process, high temperature CVD has been used to deposit an epitaxial layer on top of the seed layer 2a, an established technique common in the microelectronics processing.

### Example:

AIC seed layers 2a have been prepared on spin-on flowable oxide 1b covered 5×5 cm² alumina samples 1a following the procedure described above. The conditions were such that the AIC layers 2a covered the complete surface. No attempt was made at removing the islands 3 from the seed layer 2a. Si layers 2b were deposited on these samples in a commercial single-wafer epitaxial reactor (Epsilon ASM) with trichlorosilane diluted in H2, at atmospheric pressure and at a temperature of 1130 °C. The deposition rate was 1.4 µm/min. In situ doping with B was done by adding diborane to the gas flow, so as to form double layers with a 0.5-3 µm thick p+ region (~ 10¹⁹ cm-3) and a 0.5-3 µm thick p region (variable doping).

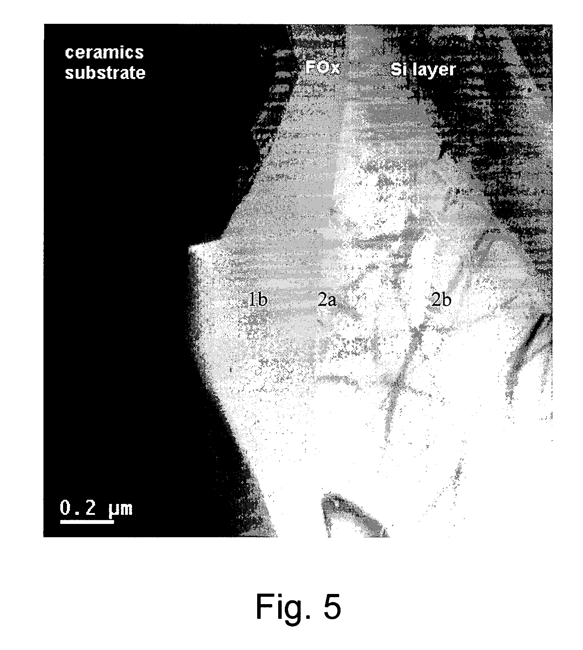

A TEM cross-section of a sample with structure alumina ceramic 1a/spin-on flowable oxide 1b/AIC seed layer 2a/epitaxial layer 2b is shown in Figure 5.

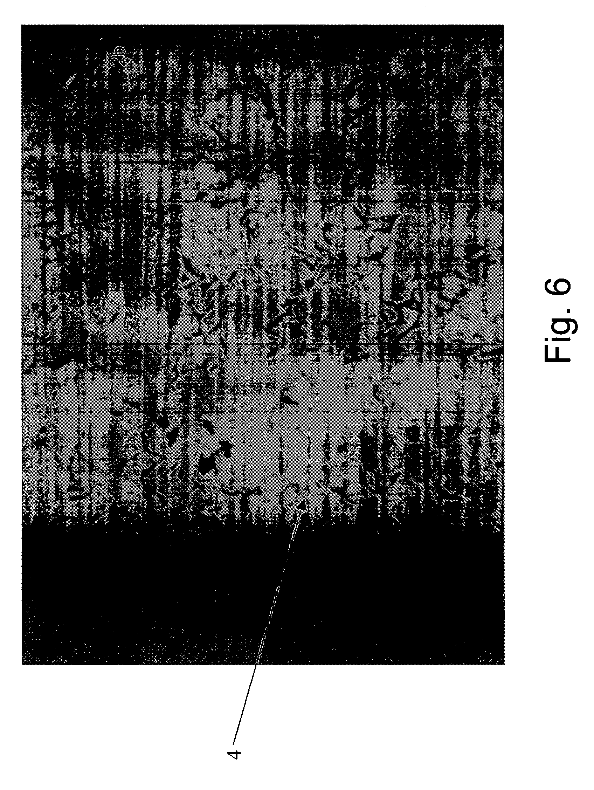

As observed before, the intermediate spin-on oxide 1b reduces the roughness but does not completely flatten the sample's surface. It does though reduce the microroughness. The quality of the epitaxial layer 2b appears very good. The seed layer 2a cannot be distinguished from the epitaxial layer 2b, no interface between the two regions being visible. The cross-sections show a very low defect density. The bent diffraction lines visible in Figure 5 do indicate that there is substantial stress in the layer. No needle-like grains, (as would be expected as a result of epitaxy on islands 3) have been observed. To determine the grain size and observe the grain size distribution, the Si layer 2b of some of the samples has been polished, a defect etch has been applied and these planar sections have been studied under an optical microscope (see Figure 6). The nominal grain size as determined by the grain boundary 4 counting technique is about 5 µm, while some grains reach 10 µm diameter or even larger.

### Solar cell processing:

Any standard solar cell manufacturing technique can be used to produce photovoltaic cells as solar cells from the obtained structures. The following example was though performed to illustrate the quality of the epitaxial layer 2b.

### Example

From samples with the structure ceramic 1a/spin-on oxide 1b/AIC seeding layer 2a/epitaxial layer 2b, simple mesa cells have been made (1×1 cm², base contact at the periphery of the cell) with the following process:
1. Emitter diffusion: P-diffusion from a P-doped pyrolithic oxide
2. Bulk and surface passivation: hydrogenation and nitride deposition in a PECVD system
3. Mesa etching: definition of the cell area (1 cm²) by photolithography and etching in a silicon etch solution
4. Side contact formation: shadow evaporation of Al and sintering
5. Emitter contact formation: photolithography, evaporation of a Ti/Pd/Ag stack and lift-off

The mesa structure is useful for relatively fast experiments to assess the quality of the material, but has an intrinsic limitation. The majority carriers (holes) have to travel a large distance to reach the base contact at the periphery, over a path with low conductance, the thin p+ layer. Therefore it is normal that the series resistance is rather high.

As example table 2 shows the illuminated IV parameters of these solar cells for various doping levels. The best efficiency so far with diffusion emitter is 5.0 %, with a Voc of 460 mV. The shunt resistance is not a problem, with Rsh above 1000 ohm cm² for all samples. The series resistance is as expected rather high, exceeding 3 ohm cm² for the best cell. The base doping level appears to have a minor impact on the cell parameters.

**Table 2**

| Nbase (cm⁻³) | J_{SC}(mA/cm²) | V_{OC} (mV) | FF(%) | Eff.(%) |
|---|---|---|---|---|
| 5' 10¹⁵ | 16.0 | 410 | 62.6 | 4.1 |
| 1'10¹⁶ | 16.3 | 411 | 62.7 | 4.2 |
| 3'10¹⁶ | 16.6 | 412 | 61.3 | 4.2 |
| 1'10¹⁷ | 16.1 | 428 | 61.2 | 4.2 |

These results are the best reported on ceramic substrates for techniques where no silicon (re-)melting is involved. The Voc in the range 410 - 460 mV is dominated by recombination in the junction space charge region and indicates a low minority carrier lifetime. Using Taretto's formula for determination of the effective diffusion length from IV parameters [U. Rau K. Taretto, J. H. Werner, J. Appl Phys. 93 (2003) 5447], we find a L_{eff} of 0.6-1.3 µm. This should not be considered as a precise value as it relies on some assumptions about not well-known material parameters (e.g. electron mobility), but clearly indicates that the diffusion length is at present substantially lower than the active layer thickness.

Additional experiments have been performed to support the present invention, which are represented in Table 3 and corresponding Figures.

**Table 3**

| Samples | Substrate | Oxide layer | AIC layer |
|---|---|---|---|
| 1, Fig. 8a | mullite | No | 200nm AI |
| | polished | | 230nm Si |
| 4, Fig. 7 | mullite | No | 200nm Al |
| | not polished | | 230nm Si |
| 5, Fig. 10a | mullite | Flowable | 200nm Al |
| | polished | Oxide (Fox) | 230nm Si |
| 8, Fig. 9 | mullite | Fox | 200nm Al |
| | not polished | | 230nm Si |
| 9, Fig. 11a | Alumina | Fox | 200nm Al |
| | | | 230nm Si |

All pictures shown in the respective figures are taken with an optical microscope with the same magnification. The long side of the picture corresponds to a distance of 127 µm, the short side to a distance of 95.5 µm.

It is to be noted that the ceramic substrates used in this experiment are commercial mullite substrates. The polishing of these substrates leads to large open porosity (pores several micron deep and wide), as illustrated in Fig. 12, Fig. 13 and Fig. 14. The quality of the AIC film should be evaluated on the material between these large pores.

### Comparison MIC directly on polished and non-polished substrates (no intermediate micro flattening layer, e.g. spin-on oxide, being applied)

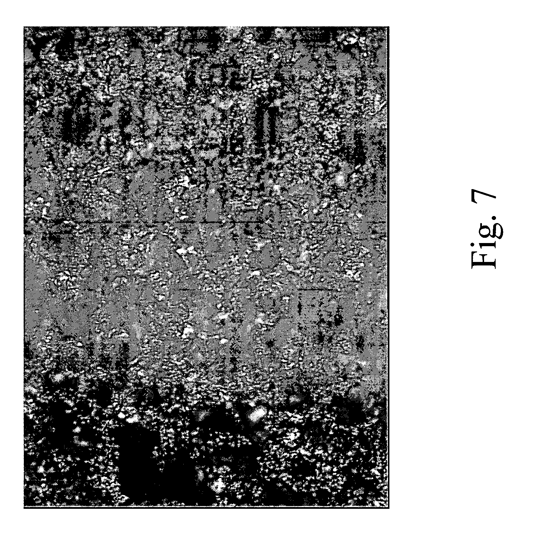

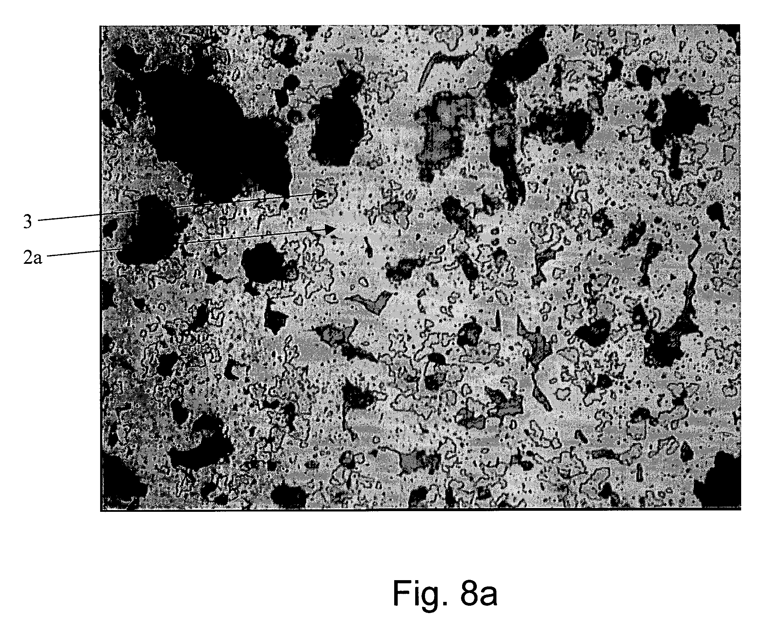

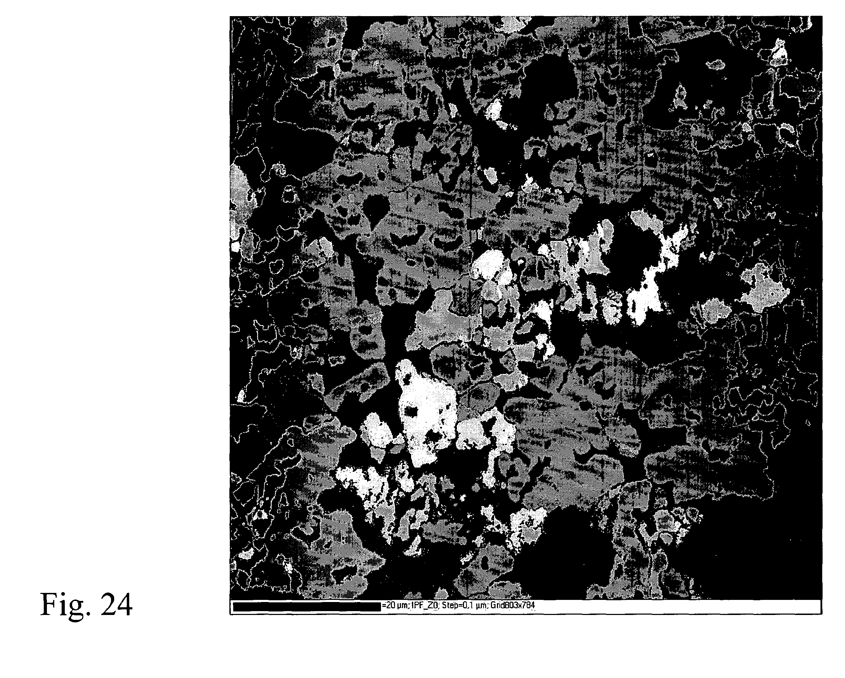

Sample 4: non-polished mullite/AIC is illustrated in Fig. 7 Sample 1: polished mullite/AIC is illustrated in Fig. 8 and Fig 24 (EBSD map).

Sample 1 is better than sample 4, i.e. it gives better results to apply AIC onto a polished substrate than to a non-polished substrate:
- sample 4 (Fig. 7) is much more rough than sample 1 (Fig. 8)
- Its possible to see the Si seeding layer 2a in sample 1 and the islands 3 have sharp contours. For sample 4 the seeding layer 2a and the islands 3 cannot easily be identified.
From the EBSD map of sample 1, it was derived that the maximum diameter of the grains is about 17.9 microns.

Doing the MIC process on a polished ceramic substrate 1a does lead to larger grain sizes and less islands 3 than on a non-polished ceramic substrate.

### Comparison MIC on non-polished substrates with and without micro flattening layer, e.g. spin-on oxide

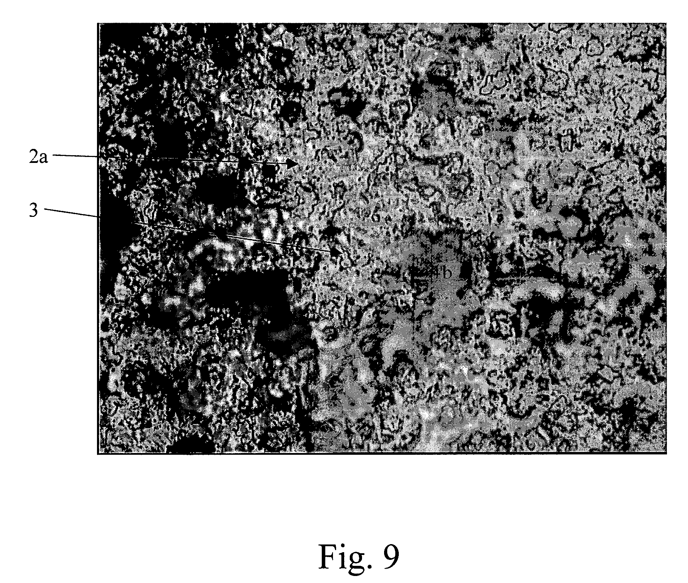

Sample 4: non-polished mullite/AIC is illustrated in Fig. 7 Sample 8:non-polished mullite/sp-on ox/AIC is illustrated in Fig.9

Sample 8 (Fig.9) is better than sample 4 (Fig.7), i.e. it gives a better result to apply AIC onto a non-polished substrate with flattening layer than onto a non-polished substrate without flattening layer:
- sample 4 (Fig.7) is more rough than sample 8 (Fig.9)
- Its possible to see the Si seeding layer 2a and islands 3 in sample 8. For sample 4 the seeding layer 2a and the islands 3 cannot easily be identified.

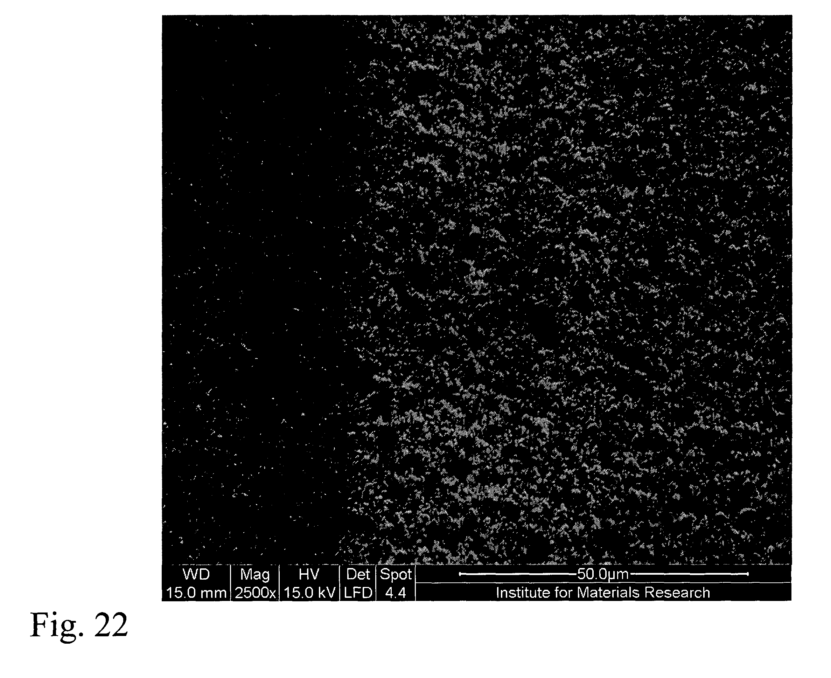

Fig. 1 and Fig. 22 (SEM): Alumina/AIC.

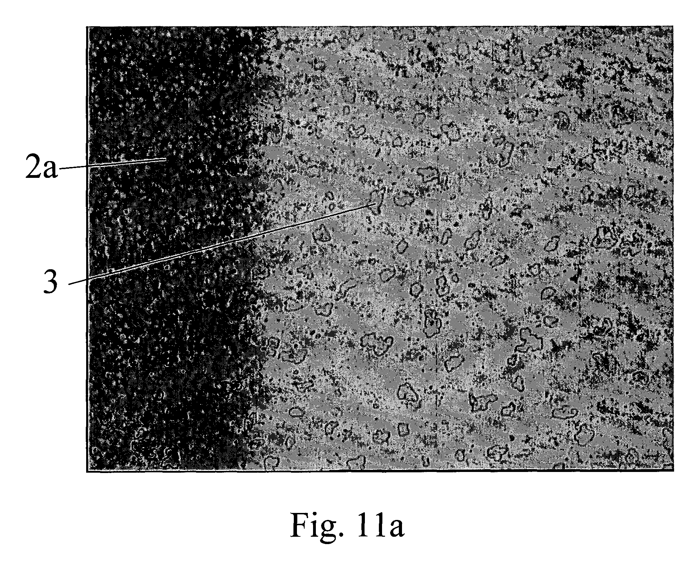

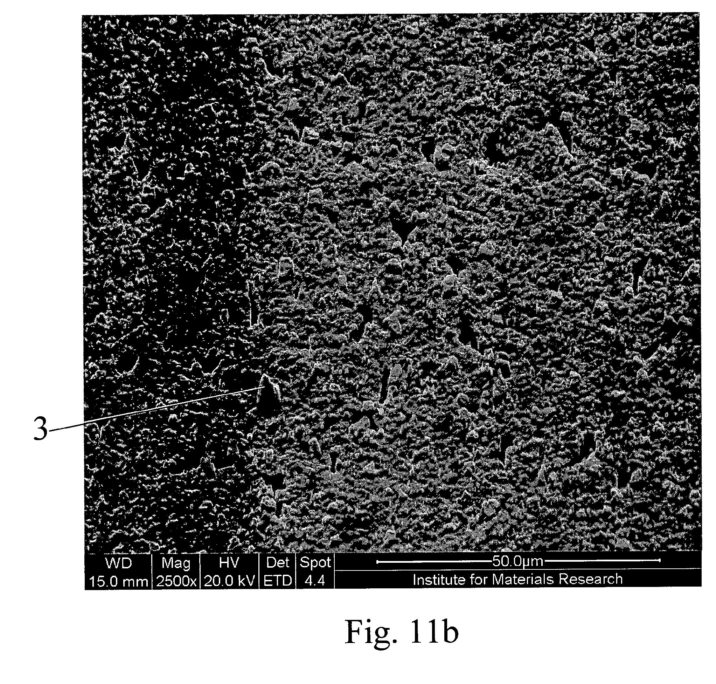

Fig. 3 and Fig. 11b (SEM): Alumina/spin-on oxide/AIC
Samples in Fig 3 and Fig. 11b are better than samples in Fig. 1 and Fig. 22, which again indicates that it gives a better result to apply AIC onto a non-polished substrate with flattening layer than onto a non-polished substrate without flattening layer:
- Sample in Fig. 1 is more rough than sample in Fig. 3
- Sample in Fig. 1 has a lot more islands 3 than the sample in Fig. 3

Using a micro flattening layer, e.g. spin-on oxide, leads to a substantial improvement of the MIC layer (larger grains, less islands) compared to the case without micro flattening layer.

### Comparison MIC on polished substrates with and without micro flattening layer, e.g. spin-on oxide

Sample 1: polished mullite/AIC is illustrated in Fig. 8a and Fig 24 (EBSD map).

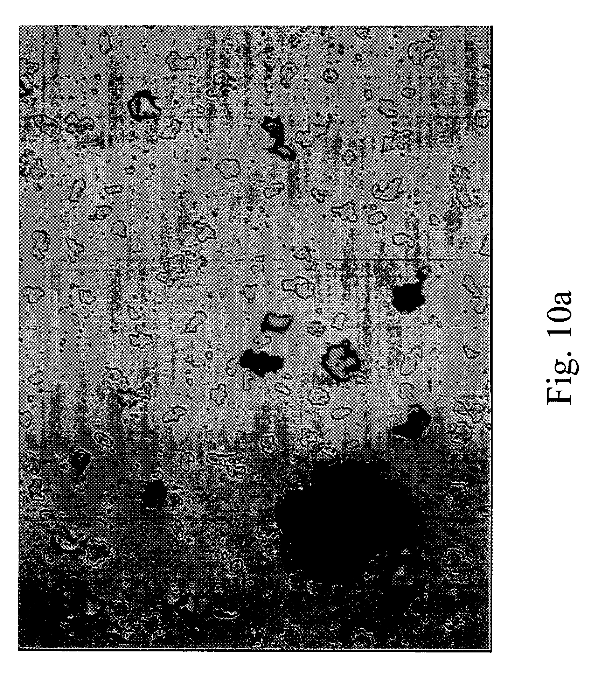

Sample 5: polished mullite/spin-on oxide/AIC is illustrated in Fig. 10a and Fig. 25 (EBSD map)

From an electron backscattering diffraction (EBSD) map of sample 1 (Fig. 24), the maximum diameter of the grains was found to be 17.9µm. Fig.8b is a SEM image of such a sample, where it is possible to see the holes in the Si seed layer and the islands 3 on top of the Si seed layer. Besides the holes in the seeding layer there are also holes in the substrate, as no flattening layer was applied to fill those holes.

From an electron backscattering diffraction (EBSD) map of sample 5 (Fig. 25), the maximum diameter of the grains was found to be 17.1 µm. Fig.10b is a SEM image of such a sample. The density of holes and islands is decreased in comparison with sample 1. The big holes in the substrate are still present; the flattening layer used was not capable to completely fill these holes.

When comparing both polished mullite samples, it can be seen that:
- the use of a flattening layer decreases the density of islands (positive effect)
- the use of a flattening layer decreases the density of holes in the seeding layer (good effect)
- there is not a big difference in grain size between both, using a flattening layer gives a slightly higher average grain size

Without being bound by theory, a possible explanation could be as follows: mullite is microflat and macroflat on some areas due to polishing. The flattening layer reduces the number of areas still having microroughness, which results in better seed layers, with less holes and islands. But because polished mullite per se is already microflat and macroflat on many areas of the substrate, the influence of the flattening layer is less than with alumina (see below).

Sample 5 is better than sample 1, i.e. it gives a better result to apply AIC onto a polished substrate with micro flattening layer than to apply in onto a polished substrate without micro flattening layer.
- Sample 5 has less islands 3 and smaller cover of islands than sample 1
- Sample 5 has less holes (is more continuous) than sample 1

Using a micro flattening layer, e.g. spin-on oxide, leads to a substantial improvement of the MIC layer (larger grains, less islands) compared to the case without micro flattening layer, and this for both polished and unpolished substrates. There therefore appears to be a beneficial effect from using a micro flattening layer before applying MIC, e.g. AIC.

TEM pictures give also a proof for the increased grain size when using a flattening layer, e.g. spin-on oxide.

### Comparison MIC on mullite and alumina substrates with micro flattening layer, e.g. spin-on oxide

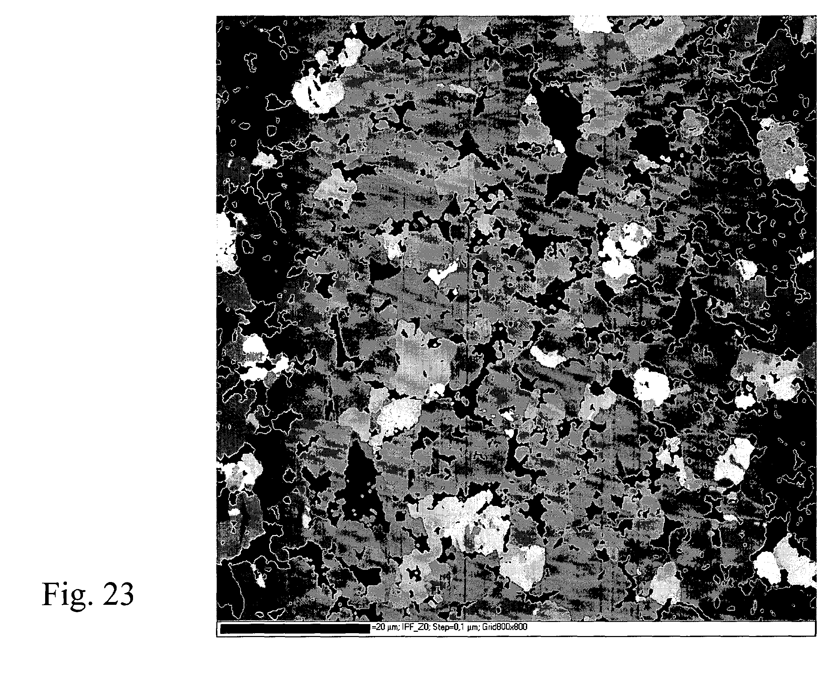

Sample 5: polished mullite/spin-on oxide/AIC is illustrated in Fig.10a, a SEM image in Fig 10b.
Sample 9: alumina/FOx/poly Si is illustrated in Fig.11a, its EBSD map in Fig. 23 and a SEM image of the same area in Fig 11b.

From an electron backscattering diffraction (EBSD, see Fig. 23) map of sample 9, the maximum diameter of the grains was found to be 11.8µm. Grains with a diameter larger than 5µm covered 80% of the area. Fig.11b is a SEM image of such a sample, where it is possible to see the holes in the poly Si layer and the islands 3 on top of the poly Si layer.

An EBSD pattern is related to grain orientation. At places where holes and islands are located is not always possible to determine the orientation due to partly shadowing of the EBSD patterns. For the above sample it was possible to determine the orientation on 86.1% of the surface. Corresponding EBSD measurement on alumina samples without FOx gives only orientation data on 0.3% of the surface, which shows that the surface, where there are a lot of islands, is too rough.

Comparing this to the results for sample 5 already given above (maximum diameter of the grains 17.1µm) shows bigger grains size between the open porosities on mullite samples than on alumina samples. Polished mullite samples are from the beginning less rough than alumina, which results in a bigger difference between samples with and without spin-on oxide for alumina than for mullite. For both types of samples with spin-on oxide, mullite gives slightly better results than alumina.

The above description indicates that by providing a surface with reduced or substantially no microroughness, a much better MIC, e.g. AIC, seed layer can be obtained.

It has been found furthermore that by removing the macroroughness the MIC, e.g. AIC, process is further improved, though the improvement is less than when going from a microrough to a microflat surface. Obtaining a macroflat surface can for instance be achieved by twice spinning a flowable oxide over a surface. This can be seen from Fig.16 compared to Fig.17, the first one showing a cross-section of a sample ceramic 1a/spin-on oxide 1 b/AIC layer 2a, and the second one showing a cross-section of a sample ceramic 1a/spin- on oxide 1b/AIC layer 2a, with double spin-on oxide layer. In the case of Fig.17, the spin-on oxide layer 1 b/AIC layer 2a interface is both micro- and macroflat.

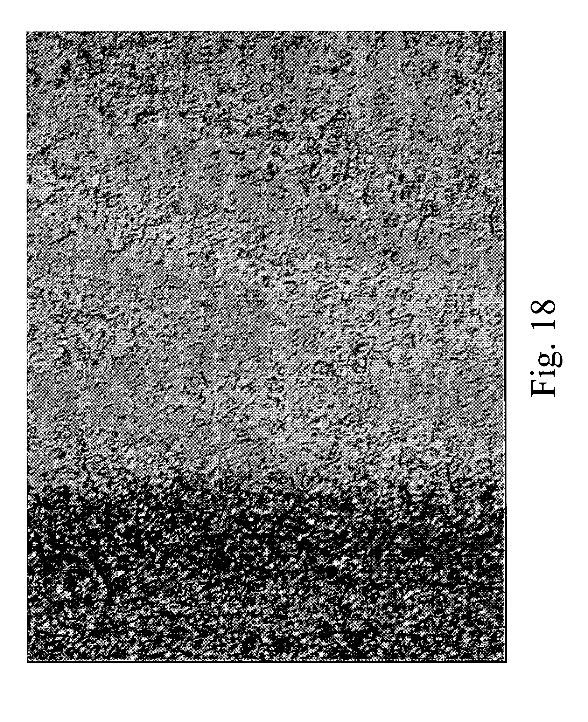

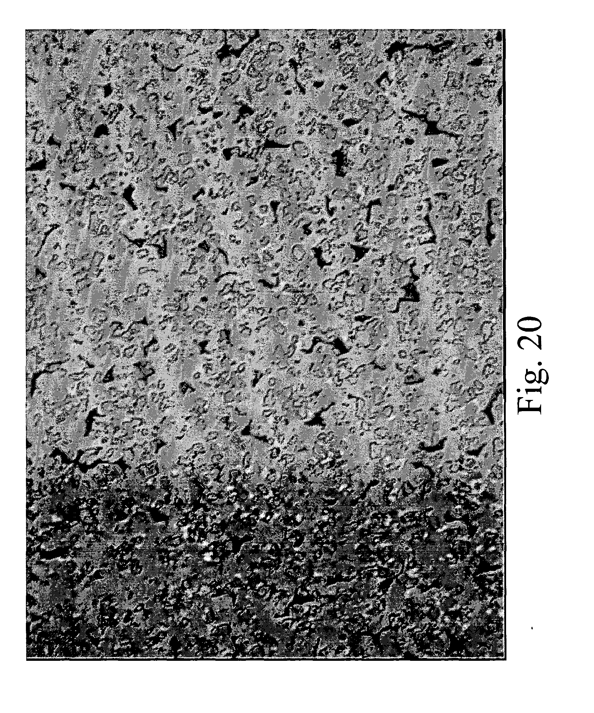

Fig.18, resp. 20 show a top view optical microscope picture of a sample ceramic 1a/spin-on oxide 1b/AIC layer 2a after aluminium removal. In case of Fig.18, the spin-on oxide layer 1b consists of one single layer, which in case of Fig.20, the spin-on oxide layer 1b consists of a double spin-on oxide layer. It can be seen that in case of the double spin-on oxide layer a flatter seed layer is obtained than in case of the single spin-on oxide layer. The AIC layer in Fig.18 has a lower quality compared to the quality of the AIC layer in Fig. 11a (both alumina/spin-on oxide/AIC), because the spin-on oxide layer is thinner (more macroroughness).

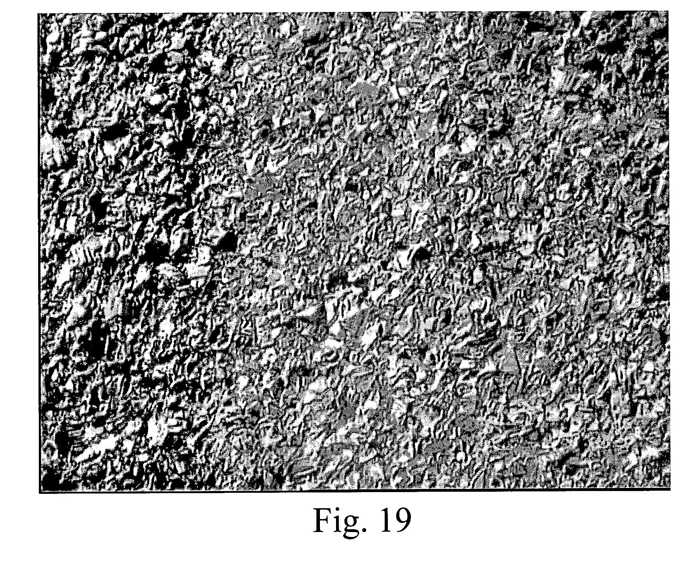

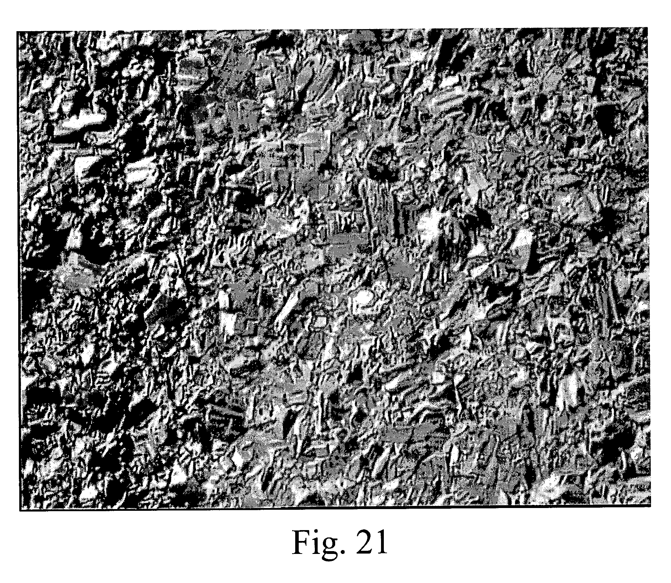

Fig.19, resp. 21 show a top view optical microscope picture of a sample ceramic 1a/ spin-on oxide 1b/AIC layer 2a after epitaxial growth. In case of Fig.19, the FOx layer 1b consists of one single layer, which in case of Fig.21, the spin-on oxide layer 1b consists of a double spin-on oxide layer. It can be seen that in case of the double spin-on oxide layer bigger structures are obtained than in the case of one single spin-on oxide layer, which is an indication for bigger grains, and thus better epitaxial quality.

This illustrates that macroflattening furthermore has an advantageous effect on grain sizes obtained by epitaxial growth onto an MIC seed layer: larger grain sizes are obtained.

## Claims

1. Method for the formation of a crystalline silicon layer on a face of a substrate, said face being microrough, comprising the steps of:
providing said substrate;
reducing said microroughness of said face;
performing a metal induced crystallisation process on said face.

2. Method according to claim 1, whereby the reduction of said microroughness of said microrough face is performed by depositing a microflattening layer on said microrough face.

3. Method according to claim 2, wherein said microflattening layer is a dielectric layer.

4. Method according to claim 3, wherein said dielectric layer comprises a spin-on dielectric, a flowable dielectric, a dip-on dielectric or a spray-on dielectric.

5. Method according to claim 4, whereby said dielectric layer comprises a spin-on glass or SiO₂ or another oxide

6. Method according to any of claims 1 to 5, wherein said substrate comprises a ceramic material, glass or a glass-ceramic material.

7. Method according to claim 6, wherein said substrate comprises mullite, alumina or Silicon Nitride.

8. Method according to any of claims 1 to 7, wherein said microrough face has a microroughness below 1 rad/µm after the step of reducing said microroughness.

9. Method according to claim 1 to 8, wherein an additional step of reducing the macroflatness is performed before the step of performing a metal induced crystallisation process on said face.

10. Method according to claim 9, wherein an additional step of reducing the macroflatness is performed after the additional step of reducing said microroughness of said face.

11. Method according to claim 1 to 10, whereby said metal induced crystallisation process is a Aluminum induced crystallisation process.

12. Method according to claim 11, whereby said Aluminum induced crystallisation process comprises the steps of:
a. Aluminium deposition;
b. Aluminium oxidation;
c. Amorphous silicon deposition;
d. Annealing;
e. Al removal

13. Method according to any of claims 1 to 12, further comprising the steps of:
epitaxial silicon layer deposition
solar cell processing

14. Method according to claim 13, whereby the process of said solar cell processing comprises the steps of:
- Phosphor diffusion
- Bulk and surface passivation
- Metallisation
- Isolation.

15. A substrate for use in preparation of a semiconductor device comprising :
a substrate with a buried microrough surface,
a microflattening layer on the microrrough surface, and
a seed layer.

16. A substrate according to claim 15 further comprising a crystalline semiconductor layer on the seed layer.

17. A solar cell including the substrate of claim 15 or 16.
